(19)

Europäisches
Patentamt
European
Patent Office
Office européen
des brevets

(11) **EP 4 016 944 A1**

(12) **EUROPEAN PATENT APPLICATION**
published in accordance with Art. 153(4) EPC

(43) Date of publication:
**22.06.2022 Bulletin 2022/25**

(21) Application number: **20865766.8**

(22) Date of filing: **16.09.2020**

(51) International Patent Classification (IPC):
**H04L 25/49** *(2006.01)*

(52) Cooperative Patent Classification (CPC):
**H04L 25/49**

(86) International application number:
**PCT/CN2020/115679**

(87) International publication number:
**WO 2021/052376 (25.03.2021 Gazette 2021/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **20.09.2019 CN 201910893365**

(71) Applicant: **ZTE Corporation
Shenzhen, Guangdong 518057 (CN)**

(72) Inventors:
• **LIN, Guangliang
Shenzhen, Guangdong 518057 (CN)**
• **YUAN, Jing
Shenzhen, Guangdong 518057 (CN)**
• **NING, Dongfang
Shenzhen, Guangdong 518057 (CN)**
• **DAI, Zhengjian
Shenzhen, Guangdong 518057 (CN)**

(74) Representative: **WBH Wachenhausen
Patentanwälte PartG mbB
Müllerstraße 40
80469 München (DE)**

(54) **DIGITAL PRE-DISTORTION METHOD FOR MULTI-BAND SIGNAL, AND ELECTRONIC DEVICE AND READABLE STORAGE MEDIUM**

(57) The embodiments of the present application relate to the field of digital signal processing. Disclosed are a digital pre-distortion method for a multi-band signal, and an electronic device and a readable storage medium. In the present application, the digital pre-distortion method for a multi-band signal comprises: determining a possible power amplifier distortion according to the configuration of a signal sent by a cell; selecting a basis function of pre-distortion according to the possible power amplifier distortion; solving, according to a pre-collected reference multiband signal and a corresponding feedback signal, the selected basis function to obtain a pre-distortion parameter; and generating a pre-distortion signal according to the selected basis function and a multi-band signal input during the processing of the pre-distortion parameter.

```
          Start
            │
            ▼
Determine a possible power              101
amplifier distortion according to
configuration of a signal issued by a
cell
            │
            ▼
Select basis function of pre-distortion 102
according to the possible power
amplifier distortion
            │
            ▼
Solve, according to a pre-collected     103
reference multiband signal and a
corresponding feedback signal, the
selected basis function to obtain a
pre-distortion parameter
            │
            ▼
Process the input multiband signal      104
according to the selected basis function
and the pre-distortion parameter to
generate a pre-distortion signal
            │
            ▼
          End
```

Fig. 1

## Description

### CROSS-REFERENCE TO RELATED APPLICATION

The present application is filed on the basis of Chinese Patent Application 201910893365.4 filed on September 20, 2019, and claims priority to the Chinese patent application, the entire contents of which are incorporated herein by reference.

### TECHNICAL FIELD

The embodiments of the present application relate to the field of digital signal processing, and in particular to a digital pre-distortion method for a multiband signal, an electronic device and a readable storage medium.

### BACKGROUND

The increasing demand for high-speed data services in modern times promotes the continuous development of communication systems with the purpose of supporting higher date transmission rates. Each generation of communication standards will comprehensively utilize various technologies to realize higher data transmission rates. For example, the LTE-Advanced system adopts the orthogonal frequency division multiplexing (OFDM) technology and the multiple input multiple output (MIMO) technology with high spectrum utilization. Increasing the system bandwidth to increase the channel capacity is a general trend in the evolution process of mobile communication technologies. Since the existing spectrum resources have been mostly occupied, the remaining spectrum resources are likely to be discrete. In the LTE-Advanced, idle and scattered bands are effectively aggregated to form a whole spectrum by the carrier aggregation technology, so as to realize the desired system bandwidth. Inter-band discontinuous carrier aggregation is performed on a plurality of different bands to generate a plurality of multiband signals having a band interval that is greater than the bandwidth of each band signal. Therefore, multi-frequency transmitters become a development trend in the future.

Unlike single-band signals, the distortion of multiband signals after entering a power amplifier is more complex. At present, the input signal is predistored by digital pre-distortion (DPD), and then predistored signal is input into the amplifier. The processing performance of pre-distortion for multiband signal at present is unsatisfactory.

### SUMMARY

An objective of the embodiments of the present application is to provide a digital pre-distortion method for a multiband signal, an electronic device and a readable storage medium.

An embodiment of the present application provides a digital pre-distortion method for a multiband signal, including: determining a possible power amplifier distortion according to the configuration of a signal issued by a cell; selecting basis function of pre-distortion according to the possible power amplifier distortion; solving, according to a pre-collected reference multiband signal and a corresponding feedback signal, the selected basis function to obtain a pre-distortion parameter; and, processing an input multiband signal according to the selected basis function and the pre-distortion parameter to generate a pre-distortion signal.

An embodiment of the present application further provides an electronic device, including: at least one processor; and, a memory communicatively connected to the at least one processor, where the memory stores instructions executable by the at least one processor, which when executed by the at least one processor, causes the at least one processor to carry out the digital pre-distortion method for a multiband signal described above.

An embodiment of the present application further provides a computer-readable storage medium having computer programs stored thereon which, when executed by a processor, cause the processor to carry out the digital pre-distortion method for a multiband signal described above.

The foregoing description merely shows the summary of the technical schemes of the present application. In order to make the technical means of the present application more clearly, the technical means may be implemented in accordance with the contents in this description and, in order to make the above and other objectives, features and advantages of the present application more obvious, the embodiments of the present application will be illustrated hereinafter.

### BRIEF DESCRIPTION OF DRAWINGS

One or more embodiments will be described with reference to the drawings corresponding thereto. These descriptions do not limit the embodiments. Like elements are represented by like reference numerals in the drawings, and the figures in the drawings do not constitute scale limits, unless otherwise specified.

FIG. 1 is a flowchart of a digital pre-distortion method for a multiband signal according to a first embodiment of the present application;

FIG. 2 is a flowchart of determining a possible power amplifier distortion in the digital pre-distortion method for a multiband signal according to the first embodiment of the present application;

FIG. 3a is a schematic diagram of a multiband LTE signal in an example of the digital pre-distortion method for a multiband signal according to the first embodiment of the present application;

FIG. 3b is a schematic diagram of a power amplifier distortion possibly generated by the multiband LTE signal in an example of the digital pre-distortion method for a multiband signal according to the first embodiment of the present application;

FIG. 4 is a flowchart of a digital pre-distortion method for a multiband signal according to a second embodiment of the present application;

FIG. 5 is a flowchart of an optimization process in the digital pre-distortion method for a multiband signal according to the second embodiment of the present application;

FIG. 6 is a schematic diagram of an application scenario of a digital pre-distortion apparatus in the digital pre-distortion method for a multiband signal according to the first or second embodiment of the present application; and

FIG. 7 is a schematic structure diagram of an electronic device according to a third embodiment of the present application.

## DETAILED DESCRIPTION

To make the objectives, technical schemes and advantages of the embodiments of the present application clearer, the embodiments of the present application will be described in detail below with reference to the drawings. However, it should be understood by a person having ordinary skills in the art that, in the embodiments of the present application, many technical details are provided to make readers better understand the present application. However, even in the absence of these technical details and various variations and modifications based on the following embodiments, the technical schemes claimed in the present application can still be implemented. The division of the following embodiments is for the convenience of description and shall not constitute any limitations to the specific embodiments of the present application. The embodiments can be combined with and referred to each other if not conflicted.

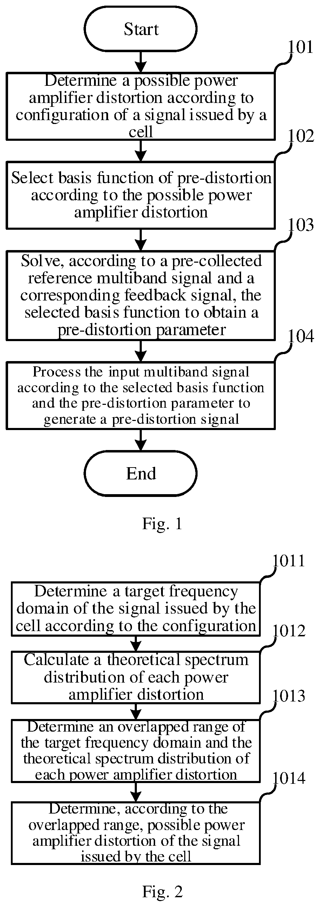

A first embodiment of the present application relates to a digital pre-distortion method for a multiband signal. The flow is shown in FIG. 1, which includes the following operations of S101, S102, S103 and S104.

At S101, a possible power amplifier distortion is determined according to the configuration of a signal issued by a cell.

The possible power amplifier distortion of the multiband signal is related to the range where the multiband signal is located and the spectrum distribution of each power amplifier distortion, so that the possible power amplifier distortion can be determined by an overlapped range of a target frequency domain where the multiband signal is located and a spectrum distribution of each power amplifier distortion, as shown in FIG. 2, which includes the following operations of S1101 to S1104.

At S1101, a target frequency domain of the signal issued by the cell is determined according to the configuration.

The configuration of the signal issued by the cell includes: a frequency point configuration and standard bandwidth (including transmitting band and receiving band) extracted from the input multiband signal. A main adjacent channel and a receiving band of the transmitted signal in each band of the multiband signal during DPD processing are determined according to the frequency point configuration and the standard bandwidth. The main adjacent channel and the receiving band can be used as the target frequency domain of the issued signal.

At S1012, a theoretical spectrum distribution of each power amplifier distortion is calculated.

The theoretical spectrum distribution of each power amplifier distortion is calculated according to the configuration of the signal issued by the cell. By taking a dual-band signal as an example, the power amplifier output of the dual-band signal may have three intermodulation or cross-modulation distortions, including in-band intermodulation, out-of-band intermodulation and inter-band cross modulation. Therefore, each calculated power amplifier distortion includes one or more of the in-band intermodulation, inter-band cross modulation and out-of-band intermodulation. The in-band intermodulation and the inter-band intermodulation fall near the signal frequency point, and a center frequency point of the out-of-band cross modulation is far away from the signal band. However, in case of a high distortion order, the spectrum expansion of the out-of-band cross modulation may affect the receiving band of the signal. Here, it can be found that the complexity of distortion of the multiband signal requires a high linearization ability of the DPD.

Continue to explain, according to signal time domains being multiplied to obtain frequency domain convolution, the center frequency point and bandwidth of the spectrum under different distortions in multiple bands are calculated. The distortion order to be focused can be preset. The distortion lower than or equal to 7-order can be preset. Since the distortion within 7-order has a great impact, only distortions lower than 7-order are calculated to avoid a large amount of data causing complex operations.

At S1013, an overlapped range of the target frequency domain and the theoretical spectrum distribution of each power amplifier distortion is determined.

At S1014, possible power amplifier distortions of the signal issued by the cell are determined according to the overlapped range.

When the spectrum range of a certain power amplifier distortion is overlapped with the target frequency domain, it can be determined that there is this distortion in the input multiband signal.

The above S1011 to S1014 are one embodiment of determining possible power amplifier distortions according to the configuration of the signal issued by the cell; however, in practical applications, other approaches are also possible and will not be limited here.

At S102, basis function of pre-distortion are selected according to the possible power amplifier distortions.

Corresponding basis function is selected according to a correspondence between power amplifier distortion types and basis function after the power amplifier distortion type is determined.

Since the number of selected basis function may be large, many sources need to be consumed during DPD processing. Therefore, basis function are screened on the premise that the resources for DPD processing allow. In practical applications, screening can be performed according to the number of the selected basis function. For example, basis function corresponding to the possible power amplifier distortions are determined according to the possible power amplifier distortions and a correspondence between power amplifier distortions and basis function; and, if the number of the determined basis function exceeds a preset value, some basis function are screened from the determined basis function according to the importance priority of the basis function to serve as the selected basis function for pre-distortion. The importance priority can be set in advance according to the principle that a lower-order distortion is superior to a higher-order distortion. In practical applications, screening can also be performed according to the resource consumption of the basis function. The resource consumption can be determined according a multiplier, an adder or other resources required by the basis function.

Here, in a feasible method for explicitly selecting the basis function of pre-distortion, under the premise that the accuracy of pre-distortion is ensured, the number of basis function involved in subsequent calculation is decreased as far as possible, and the consumption of system resources is reduced.

The above S101 to S102 will be described below by taking a dual-band signal as an example. It is to be noted that this embodiment is merely for illustrating and describing the technical principle of a certain scheme and the effects brought about, rather than limiting.

It is assumed that the input signal is a wideband dual-band LTE signal, the transmitting bands of band 1 and band 2 are 1805 MHz to 1880 MHz and 2110 MHz to 2170 MHz, respectively, and the receiving bands of band 1 and band 2 are 1710 MHz to 1785 MHz and 1920 MHz to 1980 MHz, respectively. It is assumed that a transmitted signal $X_1$ of the band 1 has a bandwidth of 35 MHz: 1825 MHz to 1860 MHz, and a transmitted signal $X_2$ of the band 1 has a bandwidth of 60 MHz: 2110 MHz to2170 MHz. The dual-band signal is divided into bands for DPD processing by taking 1987.6 MHz as a separation point.

Firstly, the frequency point configuration and standard bandwidth of the dual-band signal are extracted.

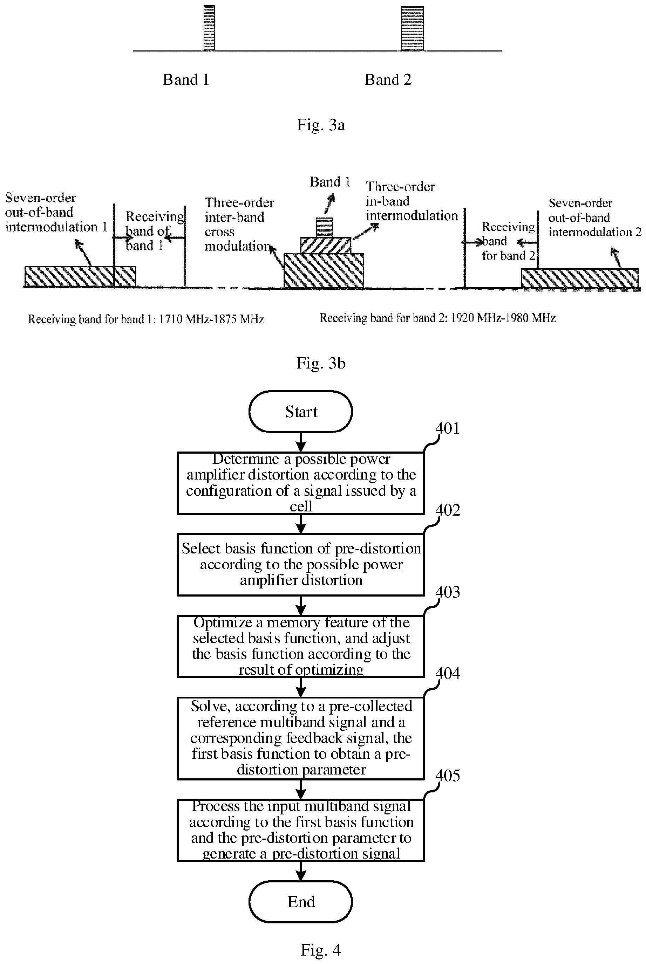

In this embodiment, as shown in FIG. 3a, the transmitted signal of the band 1 has a center frequency point of 1842.5 MHz and a bandwidth of 35 MHz, and the transmitted signal of the band 2 has a center frequency point of 2140 MHz and a bandwidth of 60 MHz.

Secondly, main adjacent channels and receiving bands of the two bands are calculated as respective "target frequency domains", respectively, and a distortion distribution overlapped with the "target frequency domains" is selected.

In this embodiment, the target frequency domain of the band 1 is 1790 MHz to 1895 MHz, 1710 MHz to 1785 MHz and 1920 MHz to 1980 MHz, and the target frequency domain of the band 2 is 2050 MHz to 2230 MHz. It is preset that the DPD processing needs to focus on distortions within 7-order. By taking the DPD processing of the band 1 as an example, the distortions within 7-order of the dual-band DPD include:

in-band intermodulation: $X_1 * (X_1 * X_1^H)^a$ a = 1,2,3 ;

inter-band cross modulation: $X_1 * (X_1 * X_1^H)^a * (X_2 * X_2^H)^b$ ; a,b = 0,1,2,3 , $1 \leq a+b \leq 3$;

out-of-band                    intermodulation:                    $X_1 * (X_1 * X_1^H)^a * (X_2 * X_2^H)^b * (X_1 * X_2^H)^c$

$X_1 * (X_1 * X_1^H)^a * (X_2 * X_2^H)^b * (X_2 * X_1^H)^c$ ; $c = 1,2,3$ , $a,b = 0,1,2,3$ , $1 \leq a+b+c \leq 3$;

where $X_1^H$, $X_2^H$ represent the conjugates of the input dual-band signals $X_1$, $X_2$, respectively.

By taking in-band intermodulation as an example, when a=1, $X_1 * X_1 * X_1^H$ represents a three-order distortion; when a=2, $X_1 * (X_1 * X_1^H)^2$ represents a five-order distortion; and, when a=3, $X_1 * (X_1 * X_1^H)^3$ represents a seven-order distortion.

It can be found that the several-order distortion means that several signals (X) are multiplied. For example: $X_1 * (X_1 * X_1^H)^2 = X_1 * (X_1 * X_1^H) * (X_1 * X_1^H)$ , where five signals are multiplied, that is, a five-order distortion is represented.

With reference to FIG. 3b, a change in the center band and bandwidth under different distortions will be illustrated.

(1) Three-order in-band intermodulation $X_1 * X_1 * X_1^H$ : according to the configuration of X1 (the center frequency point is 1842.5 MHz and the bandwidth is 35 MHz), the center frequency point of a theoretical three-order in-band intermodulation is 1842.5 + 1842.5 - 1842.5 = 1842.5 MHz, and the bandwidth is 35+35+35=105 MHz, so that the spectrum range of the theoretical three-order in-band intermodulation can be obtained as 1790 MHz to 1895 MHz. it can be found that the spectrum distribution of the three-order in-band intermodulation is overlapped with the target frequency domain of the band 1. The input signal may have a three-order in-band intermodulation distortion.

(2) Three-order inter-band cross modulation $X_1 * X_2 * X_2^H$ : in accordance with the calculation similar to the above calculation, it is calculated that the center band of a theoretical three-order inter-band cross modulation is 1842.5 MHz, and the bandwidth is 155 MHz, so that the spectrum range is 1765 MHz to 1920 MHz. It can be found that the spectrum distribution of the three-order inter-band cross modulation is overlapped with the target frequency domain of the band 1. The input signal may have a three-order inter-band cross modulation distortion.

(3) Three-order out-of-band intermodulation $X_1 * X_2 * X_2^H$ : in accordance with the calculation similar to the above calculation, it is calculated that the center band of a theoretical three-order out-of-band intermodulation is 1545 MHz, and the bandwidth is 130 MHz, so that the spectrum range is 1480 MHz to 1610 MHz. It can be found that the spectrum distribution of the three-order out-of-band intermodulation is overlapped with the target frequency domain of the band 1. The input signal may have a three-order out-of-band intermodulation distortion.

(4) Seven-order out-of-band intermodulation $X_1 * (X_1 * X_2^H) * (X_2 * X_2^H)^2$ : in accordance with the calculation similar to the above calculation, it is calculated that the center band of a theoretical seven-order out-of-band intermodulation is 1545 MHz, and the bandwidth is 370 MHz, so that the spectrum range is 1360 MHz to 1730 MHz. It can be found that the spectrum distribution of the seven-order out-of-band intermodulation is overlapped with the target frequency domain of the band 1. The input signal may have a seven-order out-of-band intermodulation distortion.

Due to the space limit, only the process of determining whether the spectra of the above four power amplifier distortions are overlapped with the target frequency domain of the input signal. However, in practical applications, determination can be performed for other distortion types, respectively, for example, five-order in-band intermodulation, five-order inter-band cross modulation, five-order out-of-band intermodulation, seven-order in-band intermodulation, seven-order inter-band cross modulation, which will not be listed one by one here.

In accordance with the determination of the overlapped range, it is inferred that, during the DPD processing of the band 1, the distortions within 7-order overlapped with the "target frequency domain" and the corresponding basis function include:

three-order, five-order and seven-order in-band intermodulation: $X_1 * (X_1 * X_1^H)^a$ ; $a = 1,2,3$ ;

three-order, five-order and seven-order inter-band intermodulation: $X_1 * (X_1 * X_1^H)^a * (X_2 * X_2^H)^b$ ; $a = 0,1,2,3$ , $b = 1,2,3$ , $1 \leq a+b \leq 3$; and

seven-order out-of-band cross intermodulation:

$$X_1 * (X_2 * X_2^H)^2 * X_1 * X_2^H \, \text{、} \quad X_1 * (X_2 * X_2^H)^2 * X_2 * X_1^H \, .$$

By the similar determination process, it is continuously determined that, during the DPD processing of the band 2, the distortions within 7-order overlapped with the "target frequency domain" and the corresponding basis function include:

three-order, five-order and seven-order in-band intermodulation: $X_2 * (X_2 * X_2^H)^a$ ; a = 1,2,3; and

three-order, five-order and seven-order inter-band intermodulation: $X_2 * (X_2 * X_2^H)^a * (X_1 * X_1^H)^b$ ; a =0,1,2,3 ,b = 1,2,3 , 1 $\leq$a+b$\leq$3.

In addition, in practical applications, the distortions above 7-order can also be calculated, and will not be listed one by one here.

The processes of determining possible power amplifier distortions according to the configuration of the signal issued by the cell and selecting basis function corresponding to the distortion types have been described by examples in the above S101 to S102. It is to be noted that this embodiment is merely for illustrating and describing the technical principle of a certain scheme and the effects brought about, rather than limiting.

At S103, the selected basis function is solved according to a pre-collected reference multiband signal and a corresponding feedback signal to obtain a pre-distortion parameter.

Parameters of a DPD model can be extracted in bands by adopting the pre-collected reference multiband signal (i.e., the multiband signal to be predistored) and the feedback signal (i.e., the power amplifier output signal). In an embodiment, the parameters of the DPD model can be solved by a regularized least square method. The input and feedback signals can be aligned in terms of frequency point, delay, energy, phase, etc., and the DPD parameters are then solved.

In this embodiment, the model refers to the addition of products of multiplying a plurality of basis function by the DPD parameters, for example:

$$C_1 * X_1 * (X_1 * X_1^H) + C_2 * X_1 * (X_1 * X_1^H)^2 + C_3 * X_1 * (X_1 * X_1^H)^3 + \ldots\ldots ,$$

where $C_1, C_2, C_3, \ldots$ refer to DPD parameters.

At S104, the input multiband signal is processed according to the selected basis function and the pre-distortion parameter to generate a pre-distortion signal.

Each band part in the multiband signal is processed according to the selected basis function and the pre-distortion parameter, so that the pre-distortion signal of the respective bands is output.

As can be seen, in this embodiment, possible distortion types are determined according to the signal configuration of the signal issued by the cell, and a model is established according to the distortion types, so that the established model exactly conforms to the pre-distortion processing range required for the actual signal. Since the distortion types contained in a fixed DPD model are fixed, during the processing of the multiband signal, if the contained types are not enough, a model deficiency will be caused, and the accuracy of pre-distortion is not enough. On the contrary, if too many types are contained, i.e., the contained distortion types exceed a number of distortion types required by the current signal configuration, DPD model redundancy will be caused, and a waste of resources is thus caused. Therefore, in this embodiment of the present application, basis function are selected, and DPD parameters are solved according to the basis function selected. For the multiband signal, since the frequency configuration and standard bandwidth of the signal are different, the distortion distribution falling into the "target frequency domain" is also different. Therefore, by determining the model according to the distortion types, the signal can be accurately predistored, and the resources consumed by the system are reduced as far as possible.

In addition, in this embodiment, in the digital pre-distortion method, it is also possible to firstly determine whether the configuration of the signal issued by the cell is changed; if the configuration is changed, the S101 to S104 will be executed; and, if the configuration is not changed, the basis function matched with the initial configuration can be pre-stored, and S104 is then directly executed. Thus, the operation performed without changing the basis function can be avoided, which helps to save the power consumption of the system.

A second embodiment of the present application relates to a digital pre-distortion method for a multiband signal. The second embodiment is a further improvement on the first embodiment. The main improvement is that in the second embodiment of the present application, the memorability is improved during the selection of basis function, so that the established model has better performance during the DPD processing.

In this embodiment, the digital pre-distortion method for a multiband signal is shown in FIG. 4, including the following operationsS401 to S403.

S401 and S402 are similar to the S101 and S102 in the first embodiment, and will not be repeated here.

At S403, a memory feature of the selected basis function is optimized, and the basis function are adjusted according to a result of optimizing.

Frequency point configurations and standard bandwidths are different in memory selection. The best memory delay can be found by optimizing memory features. The memory feature refer to the memory feature points of the amplifier. Since the amplifier has a memory effect, a model with memory items can be obtained, so that a subsequently obtained model has better DPD processing performance.

In this embodiment, the memory feature of the selected basis function can be optimized by a heuristic search algorithm or a compressed sensing algorithm.

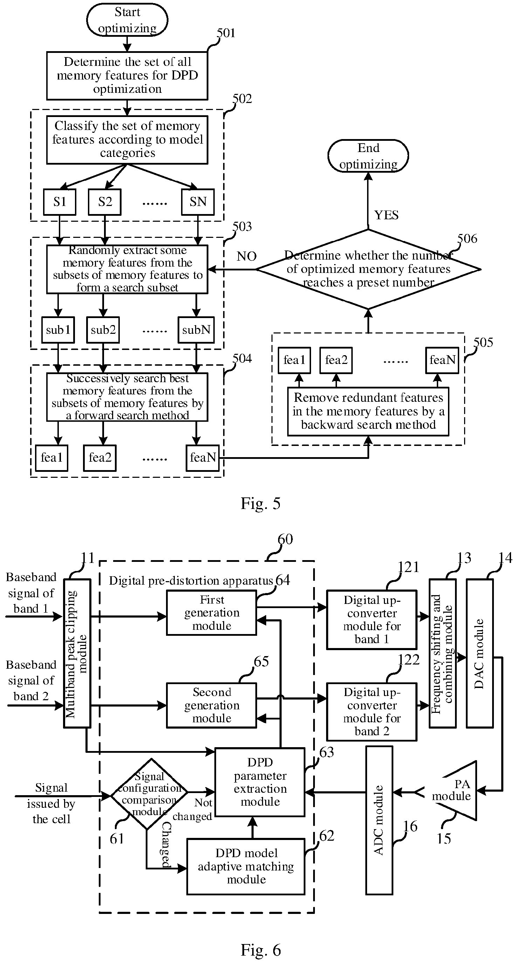

In this embodiment, the flowchart of optimizing the memory of the multiband pre-distortion model is shown in FIG. 5. By taking a heuristic search strategy as an example, a set of memory features is classified and randomly optimized forward and backward, so that the amount of calculation can be greatly reduced and the completeness of the optimized memory can be ensured. In this embodiment, it is assumed that the DPD models are classified into N categories according to the distortion types or other criteria: C1 model, C2 model, ..., CN model. Correspondingly, the set of memory features of the N categories of models is S1, S2, ..., SN, respectively, and the final result of optimizing is fea1, fea2, ..., feaN, respectively. The following operationsS501 to S506 are included.

At S501, the set of all memory features for DPD optimization is determined.

At S502, the set of memory features is classified according to model categories.

The set of memory features is classified into subsets S1, S2, ..., SN according to the model categories.

At S503, some memory features are randomly extracted from the subsets of memory features to form search subsets.

The search subsets are sub1, sub2, ..., subN.

At S504, best memory features fea1, fea1, ..., feaN are successively searched from the subsets of memory features by a forward search method. Search criterion is that: the best memory feature is added each time until the performance is no longer improved or a preset number is reached.

At S505, redundant features among fea1, fea2, ..., feaN are removed by a backward search method.

The removal criterion is that: the worst feature is removed each time until the performance is no longer improved or the number of features is less than or equal to 1.

At S506, it is determined whether the number of the optimized memory features reaches the preset number; if the number of the optimized memory features does not reach the preset number, the process returns to S503, where the set of features is reselected for a next search; and, if the number of the optimized memory features reaches the preset number, the optimization ends.

The preset number can be determined according to allowable calculation resources (multiplier, adder, etc.).

The way of optimizing the memory features have been described in the above S501 to S506, and the basis function are adjusted according to the result of optimization to obtain basis function needed. The adjustment method is described by way of an example.

For three-order in-band intermodulation, if the optimized memory features are 0, 1, 4, the basis function is adjusted from $X_1(n) * (X_1(n) * X_1^H(n))$ to the following basis function:

$$X_1(n) * (X_1(n) * X_1^H(n)),$$

$$X_1(n-1) * (X_1(n-1) * X_1^H(n-1)), \quad .$$

$$X_1(n-4) * (X_1(n-4) * X_1^H(n-4))$$

At S404, the basis function is solved according to the input signal of the digital pre-distortion apparatus and the power amplifier output signal to obtain a pre-distortion parameter.

The basis function to be solved are basis function adjusted according to the result optimization in S403. The solution method is similar to that in S103 in the first embodiment, and will not be repeated here.

At S405, the input multiband signal is processed according to the basis function and the pre-distortion parameter to generate a pre-distortion signal.

After the selected basis function are adjusted at S403, at this operation, the input multiband signal can be processed by the adjusted basis function (i.e., basis function). In addition, the way of processing the signal to generate a pre-distortion signal at this operation is similar to that in S104 in the first embodiment, and will not be repeated here.

In the above scheme, the basis function are enabled with memory, and the memory more conforms to the issued signal since the basis function are adjusted according to the result of optimization.

The division of operations in the above methods is merely for the sake of clarity; and, during embodiment, the operations can be combined into one operation, or some operations can be split into multiple operations, as long as the same logic relationship is included and all operations fall into the present patent. Adding inessential modifications or introducing inessential designs to the algorithms or flows shall fall into the protection scope of the present patent without changing the core designs of the algorithms and flows.

Continue to explain, a schematic diagram of a digital pre-distortion system corresponding to the digital pre-distortion method in the first or second embodiment in a practical application scenario may be as shown in FIG. 6. The system includes a digital pre-distortion apparatus 60, which includes:

a signal configuration comparison module 61 configured to: determine whether the configuration of a cell issued by a cell is changed; when the configuration is changed, trigger a DPD model adaptive matching module 21; and, when the configuration is not changed, trigger a DPD parameter extraction module 63;

the DPD model adaptive matching module 62 configured to determine possible power amplifier distortions according to the configuration of the signal issued by the cell, and further configured to select basis function of pre-distortion according to the possible power amplifier distortions;

the DPD parameter extraction module 63 configured to: when the configuration is not changed, extract pre-stored PDP parameters; and, when the configuration is changed, solve the basis function selected in the DPD model adaptive matching module 62 to obtain DPD parameters;

a first generation module 64 configured to generate a DPD signal for a band 1; and

a second generation module 65 configured to generate a DPD signal for a band 2.

In addition to the digital pre-distortion apparatus 60, the system in FIG. 6 further include other functional modules, the functions and effects of which are described below.

A multiband peak clipping module 11 is configured to reduce a peak-to-average ratio of the input band baseband signal to improve the operation efficiency of the power amplifier.

A digital up-converter module 121 for band 1 is configured to up-convert a digital pre-distortion signal output from the digital pre-distortion apparatus 60 into a high-speed pre-distortion signal.

A digital up-converter module 122 for band 2 is configured to up-convert a digital pre-distortion signal output from the digital pre-distortion apparatus 60 into a high-speed pre-distortion signal.

A frequency shifting and combining module 13 is configured to shift and combine a multi-frequency high-speed pre-distortion signal into a medium-frequency pre-distortion combined signal.

A digital to analog converter (DAC) module 14 is configured to convert the medium-frequency pre-distortion signal into a radio frequency pre-distortion signal through digital-to-analogy conversion.

A power amplifier (PA) module 15 is configured to amplify an analog combined signal.

An analogy to digital converter (ADC) module 16 is configured to obtain a discrete feedback signal through an analogy-to-digital converter.

The pre-distortion, up-conversion, amplification or other processing performed by the system in FIG. 6 on the multiband signal issued by the cell have been described in detail above.

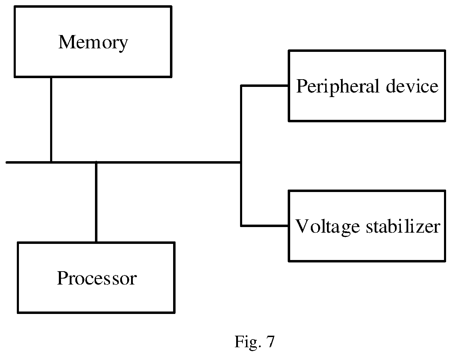

A third embodiment of the present application relates to an electronic device, as shown in FIG. 7, including: at least one processor; and, a memory communicatively connected to the at least one processor, where the memory stores instructions executable by the at least one processor, which when executed by the at least one processor, cause the at least one processor to carry out the digital pre-distortion method for a multiband signal described in the first or second embodiment.

The memory and the processor are connected by a bus. The bus may include any number of interconnected buses and bridges, and the bus connects various circuits of the one or more processor and the memory. The bus may also connect various other circuits such as peripheral devices, voltage stabilizers and power management circuits, which are well-known in the art and thus will not be further described herein. A bus interface provides an interface between the bus and a transceiver. The transceiver may be one component or multiple components, such as multiple receivers and transmitters, configured for providing a unit for communicating with various other apparatuses on a transmission medium. The data processed by the processor is transmitted on a radio medium through an antenna. Further, the antenna also receives and transmits data to the processor.

The processor is responsible for managing the bus and common processing, and can also provide various functions, including timing, peripheral interface, voltage regulation, power management and other control functions. The memory may be configured to store the data used by the processor when executing operations.

A fourth embodiment of the present application relates to a computer-readable storage medium having computer programs stored thereon which, when executed by a processor, cause the processor to carry out the method embodiments.

It should be understood by a person having ordinary skills in the art that, all or some of the operations in the methods disclosed above and the functional modules/units in the systems and devices disclosed above may be implemented as software, firmware, hardware and suitable combinations thereof. In the hardware embodiment, the division of the functional modules/units mentioned above does not necessarily correspond to the division of physical components. For example, one physical component may have multiple functions, or one function or operation may be cooperatively executed by a number of physical components. Some or all of the physical components may be implemented as software executed by processors such as central processors, digital signal processors or microprocessors, or implemented as hardware, or implemented as integrated circuits such as application-specific integrated circuits. Such software may be distributed on a computer-readable medium, and the computer-readable medium may include computer storage mediums (or non-temporary mediums) and communication mediums (or temporary mediums). As well-known to a person having ordinary skills in the art, the term computer storage medium includes volatile or non-volatile and removable or non-removable mediums implemented in any method or technology used for storing information (such as computer-readable instructions, data structures, program modules or other data). The computer storage medium includes, but not limited to, RAMs, ROMs, EEPROMs, flash memories or other memory technologies, CD-ROMs, digital video disks (DVDs) or other optical disk storages, magnetic cassettes, magnetic tapes, magnetic disk storages or other magnetic storage devices, or any other mediums which can be used to store desired information and can be accessed by computers. In addition, as well-known to a person having ordinary skills in the art, the communication medium generally contains computer-readable instructions, data structures, program modules or other data in modulation data signals such as carriers or other transmission mechanisms, and may include any information transfer mediums.

It should be understood by a person having ordinary skills in the art that the above embodiments are embodiments for implementing the present application; however, in practical applications, various variations can be made in form and details without departing from the protection scope of the present application.

**Claims**

1. A digital pre-distortion method for a multiband signal, comprising:

   determining a possible power amplifier distortion according to configuration of a signal issued by a cell;
   selecting a basis function of pre-distortion according to the possible power amplifier distortion;
   solving, according to a pre-collected reference multiband signal and a corresponding feedback signal, the selected basis function to obtain a pre-distortion parameter; and
   processing an input multiband signal according to the selected basis function and the pre-distortion parameter to generate a pre-distortion signal.

2. The digital pre-distortion method of claim 1, wherein the processing an input multiband signal according to the selected basis function and the pre-distortion parameter to generate a pre-distortion signal comprises:

   optimizing a memory feature of the selected basis function;
   adjusting the basis function according to a result of the optimizing; and
   processing the input multiband signal according to the adjusted basis function and the pre-distortion parameter.

3. The digital pre-distortion method of claim 2, wherein the optimizing is performed by a heuristic search algorithm or a compressed sensing algorithm.

4. The digital pre-distortion method of claim 1, wherein the determining a possible power amplifier distortion according to configuration of a signal issued by a cell comprises:

   determining a target frequency domain of the signal issued by the cell according to the configuration;
   calculating a theoretical spectrum distribution of each power amplifier distortion according to the configuration;

determining an overlapped range of the target frequency domain and the theoretical spectrum distribution; and determining, according to the overlapped range, the possible power amplifier distortion of the signal issued by the cell.

5. The digital pre-distortion method of claim 4, wherein each calculated power amplifier distortion comprises one or more of an in-band intermodulation, an inter-band cross modulation or an out-of-band intermodulation.

6. The digital pre-distortion method of claim 4, wherein each calculated power amplifier distortion has an order less than or equal to 7.

7. The digital pre-distortion method of claim 1, wherein selecting a basis function of pre-distortion according to the possible power amplifier distortion comprises:

determining, according to the possible power amplifier distortion and a correspondence between the power amplifier distortion and the basis function, basis function corresponding to the possible power amplifier distortion; and

in response to a number of the determined basis function exceeding a preset value, screening, according to an importance priority of the basis function, from the determined basis function, some basis functions as the selected functions of pre-distortion.

8. The digital pre-distortion method of claim 1, wherein the selected basis function is solved by a regularized least square method.

9. An electronic device, comprising:

at least one processor; and
a memory communicatively connected to the at least one processor, wherein:
the memory stores instructions executable by the at least one processor which, when executed by the at least one processor, cause the at least one processor to carry out the digital pre-distortion method of any one of claims 1 to 8.

10. A computer-readable storage medium having computer programs stored thereon which, when executed by a processor, cause the processor to carry out the digital pre-distortion method of any one of claims 1 to 8.

Start

Determine a possible power amplifier distortion according to configuration of a signal issued by a cell
101

Select basis function of pre-distortion according to the possible power amplifier distortion
102

Solve, according to a pre-collected reference multiband signal and a corresponding feedback signal, the selected basis function to obtain a pre-distortion parameter
103

Process the input multiband signal according to the selected basis function and the pre-distortion parameter to generate a pre-distortion signal
104

End

Fig. 1

Determine a target frequency domain of the signal issued by the cell according to the configuration
1011

Calculate a theoretical spectrum distribution of each power amplifier distortion
1012

Determine an overlapped range of the target frequency domain and the theoretical spectrum distribution of each power amplifier distortion
1013

Determine, according to the overlapped range, possible power amplifier distortion of the signal issued by the cell
1014

Fig. 2

Band 1                    Band 2

Fig. 3a

Seven-order out-of-band intermodulation 1 | Receiving band of band 1 | Three-order inter-band cross modulation | Band 1 | Three-order in-band intermodulation | Receiving band for band 2 | Seven-order out-of-band intermodulation 2

Receiving band for band 1: 1710 MHz-1875 MHz          Receiving band for band 2: 1920 MHz-1980 MHz

Fig. 3b

```
          ┌─────────────┐
          │    Start    │
          └─────────────┘
                 │
                 ▼                                  401
┌──────────────────────────────────────┐
│ Determine a possible power            │
│ amplifier distortion according to the │
│ configuration of a signal issued by a │
│ cell                                  │
└──────────────────────────────────────┘
                 │                                  402
                 ▼
┌──────────────────────────────────────┐
│ Select basis function of pre-distortion│
│ according to the possible power       │
│ amplifier distortion                  │
└──────────────────────────────────────┘
                 │                                  403
                 ▼
┌──────────────────────────────────────┐
│ Optimize a memory feature of the      │
│ selected basis function, and adjust   │
│ the basis function according to the   │
│ result of optimizing                  │
└──────────────────────────────────────┘
                 │                                  404
                 ▼
┌──────────────────────────────────────┐
│ Solve, according to a pre-collected   │
│ reference multiband signal and a      │
│ corresponding feedback signal, the    │
│ first basis function to obtain a pre- │
│ distortion parameter                  │
└──────────────────────────────────────┘
                 │                                  405
                 ▼
┌──────────────────────────────────────┐
│ Process the input multiband signal    │
│ according to the first basis function │
│ and the pre-distortion parameter to   │
│ generate a pre-distortion signal      │
└──────────────────────────────────────┘
                 │
                 ▼
          ┌─────────────┐
          │     End     │
          └─────────────┘
```

Fig. 4

Start optimizing

Determine the set of all memory features for DPD optimization
501

Classify the set of memory features according to model categories
502

S1    S2    ......    SN

Randomly extract some memory features from the subsets of memory features to form a search subset
503

sub1    sub2    ......    subN

Successively search best memory features from the subsets of memory features by a forward search method
504

fea1    fea2    ......    feaN

End optimizing

YES

Determine whether the number of optimized memory features reaches a preset number
506

NO

fea1    fea2    ......    feaN
505

Remove redundant features in the memory features by a backward search method

fea1    fea2    ......    feaN

Fig. 5

60

Baseband signal of band 1

Baseband signal of band 2

Multiband peak clipping module
1

Digital pre-distortion apparatus
64

First generation module

Second generation module
65

Digital up-converter module for band 1
121

Digital up-converter module for band 2
122

Frequency shifting and combining module
3

DAC module
4

Signal issued by the cell

Signal configuration comparison module
61

DPD parameter extraction module
63

DPD model adaptive matching module
62

Not changed

Changed

ADC module

PA module
15

16

Fig. 6

Fig. 7

## INTERNATIONAL SEARCH REPORT

International application No.

**PCT/CN2020/115679**

| A. | CLASSIFICATION OF SUBJECT MATTER |
|---|---|

H04L 25/49(2006.01)i

According to International Patent Classification (IPC) or to both national classification and IPC

| B. | FIELDS SEARCHED |
|---|---|

Minimum documentation searched (classification system followed by classification symbols)

H04L

Documentation searched other than minimum documentation to the extent that such documents are included in the fields searched

Electronic data base consulted during the international search (name of data base and, where practicable, search terms used)

CNPAT, WPI, EPODOC, CNKI: 多频带, 多频段, 多个频带, 多个频段, 数字预失真, 功放, 功率放大, 失真, 基函数, 模型, 参考, 反馈, 参数, 系数, multi-, multiple, band, digital predistortion, Digital Pre-Distortion, DPD, power amplifi+, distortion, basis, function, model, reference, feedback, parameter, coefficient

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 104580044 A (DATANG MOBILE COMMUNICATIONS EQUIPMENT CO., LTD.) 29 April 2015 (2015-04-29)<br>description, paragraphs [0044]-[0172], and figures 1-8B | 1-10 |
| A | CN 106685868 A (UNIVERSITY OF ELECTRONIC SCIENCE AND TECHNOLOGY OF CHINA) 17 May 2017 (2017-05-17)<br>entire document | 1-10 |
| A | CN 107707495 A (COMBA TELECOM SYSTEMS (CHINA) CO., LTD. et al.) 16 February 2018 (2018-02-16)<br>entire document | 1-10 |
| A | US 2012154041 A1 (ELECTRONICS AND TELECOMMUNICATIONS RESEARCH INSTITUTE) 21 June 2012 (2012-06-21)<br>entire document | 1-10 |

☐ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **26 November 2020** | **17 December 2020** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/115679**

| Patent document cited in search report | | | Publication date (day/month/year) | Patent family member(s) | | | Publication date (day/month/year) |
|---|---|---|---|---|---|---|---|
| CN | 104580044 | A | 29 April 2015 | None | | | |
| CN | 106685868 | A | 17 May 2017 | None | | | |
| CN | 107707495 | A | 16 February 2018 | WO | 2019080567 | A1 | 02 May 2019 |
| US | 2012154041 | A1 | 21 June 2012 | KR | 20120070057 | A | 29 June 2012 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 201910893365